Europäisches Patentamt

European Patent Office

Office européen des brevets

(11) Publication number: **0 090 193**
**B1**

# EUROPEAN PATENT SPECIFICATION

(45) Date of publication of patent specification: **08.07.87**

(21) Application number: **83102081.3**

(22) Date of filing: **03.03.83**

(51) Int. Cl.⁴: **H 05 K 9/00, H 02 M 7/10**

(54) **Voltage multiplier device for high tension equipment, in particular for applications in space.**

(30) Priority: **30.03.82 IT 2048182**

(43) Date of publication of application:
**05.10.83 Bulletin 83/40**

(45) Publication of the grant of the patent:
**08.07.87 Bulletin 87/28**

(84) Designated Contracting States:
**BE DE FR GB NL SE**

(56) References cited:
**EP-A-0 034 102**
**GB-A- 918 834**
**US-A-3 721 746**
**US-A-3 777 249**

(73) Proprietor: **FIAR S.p.A.**
**Via G.B. Grassi, 93**
**I-20157 Milano (IT)**

(72) Inventor: **Volontieri, Antonio**
**Via Vespucci, 37**
**I-20025 Legnano (Milano) (IT)**

(74) Representative: **Modiano, Guido et al**
**MODIANO, JOSIF, PISANTY & STAUB**
**Modiano & Associati Via Meravigli, 16**
**I-20123 Milan (IT)**

Courier Press, Leamington Spa, England.

EP 0 090 193 B1

## Description

This invention relates to a voltage multiplier device for high tension equipment, in particular for applications in space, of the type defined in the preamble of claim 1, and as shown e.g. from US—A—3777249.

As is known, satellite equipment, owing to the high costs of satellite launching and orbiting, as well as the difficulty or even impossibility of effecting component replacements, pose strict and often conflicting requirements. As an example, to reduce the launching cost, the weight and size of the equipment installed have to be minimized, while owing to the difficulties encountered in replacing components, it is necessary that the latter be reliable and durable. On the other hand, size reduction, especially with high tension equipment, makes the insulation problems more keenly felt and increases the likelihood of the so-called corona effect occurring, with partial discharges which do not shortcircuit the electrodes. Such partial discharges occur inside cavities or inclusions in a dielectric, which grow larger with time owing to the wall being eroded away by the discharges. Consequently, within a more or less short time, this will result in a destructive discharge taking place and failure of the equipment.

In particular with voltage multipliers, to achieve good reliability of the apparata, qualified components (capacitors, diodes, and resistors) must be selected, along with a good circuit arrangement of such components in order to minimize stray capacities, and a good insulation.

In general, insulation is the most critical factor and requires a careful study of the potential distribution.

A multiplier assembly with improved inhibition of corona discharges according to the preamble of claim 1 is known from US—A—3777249.

In view of the foregoing situation, it is a primary object of this invention to provide a voltage multiplier which is compact in size and highly reliable in operation.

A further object of the invention is to provide a voltage multiplier, wherein the likelihood of partial or destructive discharges occurring is minimized, thereby improving the apparatus durability.

Another object of this invention is to provide a voltage multiplier as indicated, which features good insulation, both outside and inside between the individual components thereof.

These and other objects, such as will be apparent hereinafter, are achieved by a voltage multiplier device for high tension equipment, in particular for spatial applications, having the characterising features of claim 1.

The features and advantages of the invention will be more clearly understood from the following description of a preferred, though not limitative, embodiment of this device, as illustrated by way of example only in the accompanying drawings, where:

Figure 1 is a general perspective view of the voltage multiplier device according to the invention;

Figure 2 is a schematical detail view of the device of Figure 1;

Figure 3 is a side view of the detail shown in Figure 2;

Figure 4 is a further detail view of the device of Figure 1, in schematical form;

Figure 5 is a side view of the detail shown in Figure 4; and

Figures 6 to 12 illustrate assembling details of the electric components of the voltage multiplier section according to the invention.

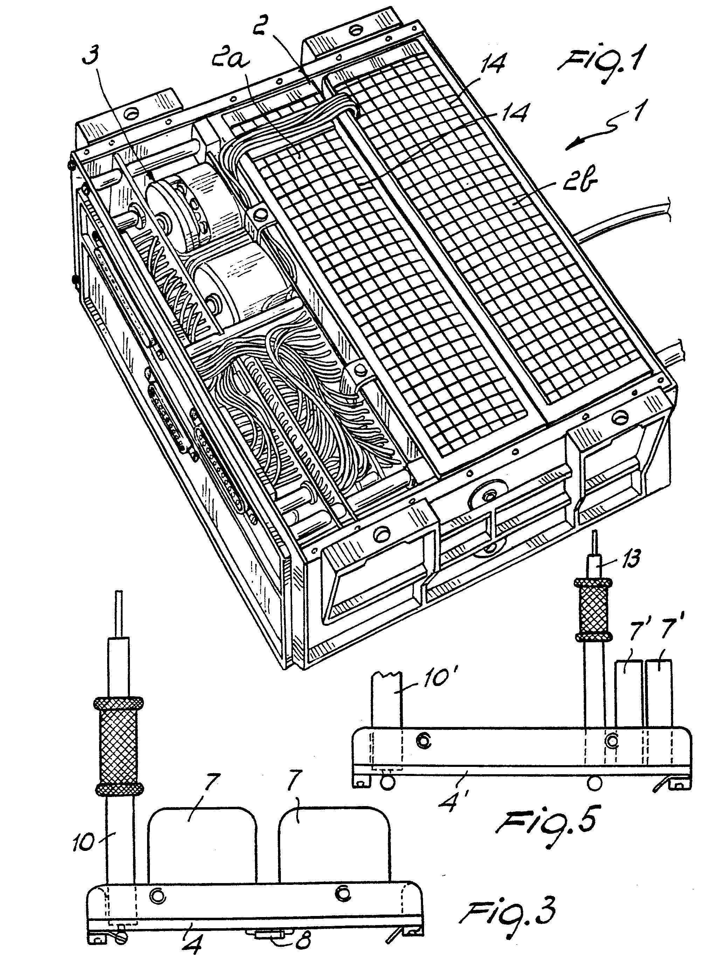

With reference to Figure 1, indicated at 1 is the "main voltage multiplier" device. Said device 1 comprises two sections, of which a first section, designated with the reference numeral 2, constitutes the voltage multiplier proper, and a second section, designated with the reference numeral 3, constitutes the driver section of the final stage of the voltage multiplier. The voltage multiplier 2 is divided, in turn, into a first element 2a and second element 2b, forming a multiplier by twelve and multiplier by thirty six, respectively. As may be seen in Figure 1, both the element 2a and element 2b of this invention are completely enclosed by a screen 14 formed from a wire mesh which is grounded.

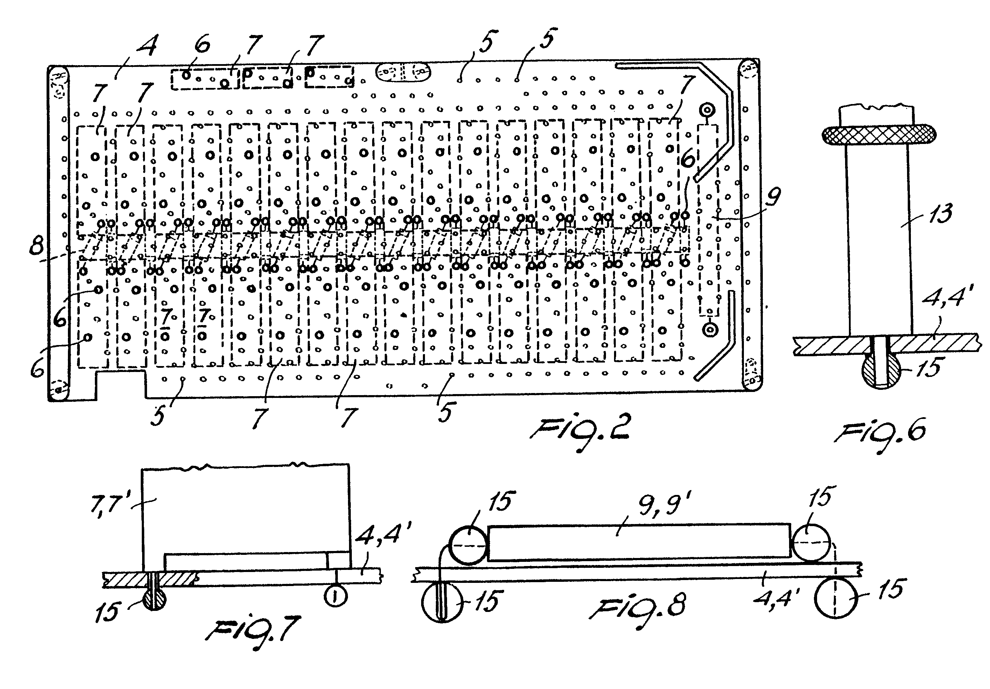

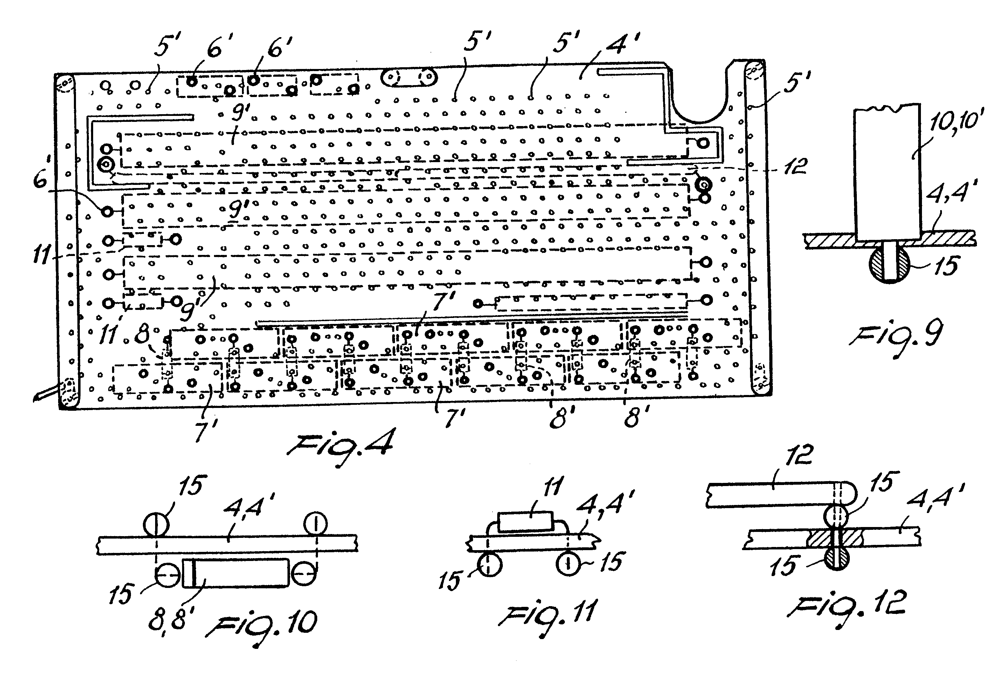

Figure 2 illustrates schematically the multiplier by thirty six. Said multiplier comprises a base 4 having holes 5 (represented as thin line circles). Thick line circles represent the soldered points 6 for assembling the components. Mounted on the base 4 are capacitors 7 (welded in the way shown in Figure 7), diodes 8 (Figure 10), and a resistor 9 (Figure 8).

Figure 3 shows a side view of the multiplier 36 of Figure 2, where the capacitors 7, diodes 8, and output cable 10 for the 36 kVolt high tension (soldered as shown in Figure 9) may be seen.

Figure 4 illustrates the multiplier-by-twelve element which, similarly to the multiplier-by-thirty six element shown in Figure 2, comprises a base 4' having holes 5' and soldered points 6'. Soldered to the base 4' are capacitors 7', diodes 8', resistors 9', resistors 11 (welded as shown in Figure 11), and a component 12 (assembled as shown in Figure 12).

Shown in thick dash lines, both in Figure 2 and Figure 4, are components 7, 7', 9, 9', 11, and 12, which are all soldered on the same side of the base, 4 or 4' and in thin dash lines, the components 8 and 8' soldered to the other side of the base.

Figure 5 is a side view of the multiplier by twelve according to Figure 4. Said side view shows the capacitors 7', output cable 13 for the 12 kVolt high tension, and output cable 10' for the 36 kVolt high tension.

Figures 6—12 illustrate the soldering of the components and high tension cables, whereby a reduction in the applied electric field can be achieved, i.e. the optimization of the potential gradient. According to this invention, metal members having surfaces of various sizes, such as balls or small cylinders 15, are provided. The dimensions of the metal surfaces 15 must be carefully determined, as is obvious to a person skilled in the art, to each time provide the best distribution.

The method for manufacturing the voltage multiplier device of this invention is also of essential importance and advantageous per se. In accordance with said method, bases are press formed with holes, onto which bases the components are then assembled while inserting at the same time the metal balls or cylinders 15. Thereafter, the thus assembled bases are placed within electrostatic screens, wherefrom air is drawn out prior to filling with the insulating polyurethane resins. The insulating polyurethane resins are cast, according to the invention, under a vacuum, in order to prevent the formation of air bubbles within the insulating dielectric which would represent weakening areas. In fact, there would otherwise be generated at said bubbles high potential differences, with attendant increased likelihood of destructive discharges taking place.

It will be appreciated from the foregoing description that the invention fully achieves its objects. In particular, that the voltage multiplier device is highly reliable, by virtue of metal surfaces being inserted therein which afford an improved distribution of the potential existing between the components, with attendant reduction of the electric field where the tension is highest.

Furthermore, the provision of holes in the component mounting bases is extremely advantageous. In fact, such holes, by extending the path of any surface discharges reduce the likelihood of such discharges occurring between components at different potentials.

Of fundamental importance to the reliability of the system is the fact that a control of the electric field has been provided in the form of screens which completely enclose the voltage multiplier section and are grounded electrically. Advantageously, such screens may be formed from wire mesh, thereby facilitating adhesion of the screen onto the insulating resins, and reducing the likelihood of air bubbles highly susceptible to discharging being formed between the screen and external surface of the dielectric. Moreover, the insulating resins are cast under a vacuum to prevent the formation of air bubbles within the dielectric.

In practicing the invention, the materials, as well as shapes and dimensions, may be any ones meeting individual application requirements.

## Claims

1. A voltage multiplier device for high tension equipment, in particular for applications in space, comprising a first section (2) including such circuit components as resistors, capacitors, and diodes (7-9, 7'-9', 11, 12) operatively and functionwise interconnected together so as to supply a high voltage, means (5, 5', 15) for optimizing the potential gradient present between the components making up said first section (2) and a driver section (3), characterized in that electrostatic screens (14) external to said first section (2) are provided for controlling the electric field present, in that said components (7-9, 7'-9', 11, 12) are carried on a common mounting base (4, 4') provided with plural holes (5, 5') for optimizing the potential gradient and in that located at terminals of said circuit components (7-9, 7'-9', 11, 12) and at interconnection and solder points (6, 6') to the common mounting base (4, 4') are metal members having surfaces (15) effective to provide an improved distribution and reduction of the electric field present within said first voltage multiplier section (2).

2. A device according to Claim 1, characterized in that said electrostatic screens (14) comprise a wire mesh completely enclosing said first voltage multiplier section (2).

3. A device according to Claims 1 and 2, characterized in that said electrostatic screens (14) controlling the electric field are kept at ground potential.

4. A voltage device according to Claim 1, characterized in that said metal members having surfaces (15) are in the form of small balls or cylinders soldered to the terminals of said circuit components and said base (4, 4').

5. A device according to Claim 1, characterized in that said first voltage multiplier section (2) is encapsulated in polyurethane resin having a high dielectric constant and being adapted to provide adequate insulation between points at different potentials for optimizing the applied electric field.

6. A method of manufacturing the voltage multiplier device for high tension equipment, in particular for applications in space, characterized in that it comprises the steps of:

press forming a mounting base for circuit components with holes interrupting the electric path of discharges and the like;

assembling said circuit components by inserting and soldering to the terminals of said components metal surfaces such as small balls and cylinders of a suitable size;

enclosing said base with said circuit components by means of a wire mesh electrostatic screen;

filling with liquid state polyurethane resins into the enclosure formed by said screen either under a very low pressure or a vacuum; and

allowing said resins to solidify.

## Patentansprüche

1. Spannungsvervielfachervorrichtung für eine Hochspannungsanlage, insbesondere für Anwendungen in der Raumfahrt, bestehend aus einer ersten Stufe (2) mit Schaltelementen wie Widerständen, Kondensatoren und Dioden (7-9, 7'-9', 11, 12), die wirkungs- sowie Funktionsmäßig zur Abgabe einer Hochspannung zusammengeschaltet sind, aus einer Einrichtung (5, 5', 15) zur Optimierung des zwischen den die erste Stufe (2) bildenden Schaltelementen auftretenden Potentialgradienten und aus einer Treiberstufe (3), dadurch gekennzeichnet, daß außerhalb der ersten Stufe (2) elektrostatische Abschirmungen (14) zur Steuerung des auftretenden elektrischen Feldes vorgesehen sind, daß die Schaltelemente (7-9, 7'-9', 11, 12) von einem gemeinsamen Montagegrundkörper (4, 4') getragen sind, der mit mehreren Löchern (5, 5') zur Optimierung des Potentialgradienten versehen ist, und daß an den Anschlüssen der Schaltelemente (7-9, 7'-9', 11, 12) sowie an Verbindungs und Lötstellen (6, 6') am gemeinsamen Montagegrundkörper (4, 4') Metallteile mit Oberflächen (15) vorgesehen sind, die eine verbesserte Verteilung und Verminderung des in der ersten Spannungsvervielfacherstufe (2) auftretenden elektrischen Feldes bewirken.

2. Vorrichtung nach Anspruch 1, dadurch gekennzeichnet, daß die elektrostatischen Abschirmungen (14) aus einem Drahtgitter bestehen, das die erste Spannungsvervielfacherstufe (2) vollständig umgibt.

3. Vorrichtung nach Anspruch 1 oder 2, dadurch gekennzeichnet, daß die das elektrische Feld steuernden elektrostatischen Abschirmungen (14) auf Massepotential gehalten sind.

4. Vorrichtung nach Anspruch 1, dadurch gekennzeichnet, daß die Metallteile mit den Oberflächen (15) in Form kleiner Kugeln oder Zylinder ausgebildet sind, die an die Anschlüsse der Schaltelemente und des Montagegrundkörpers (4, 4') angelötet sind.

5. Vorrichtung nach Anspruch 1, dadurch gekennzeichnet, daß die erste Spannungsvervielfacherstufe (2) in einem Polyurethanharz eingebettet ist, das eine hohe Dielektrizitätskonstante aufweist und zur Schaffung einer geeigneten Isolierung zwischen auf unterschiedlichen Potentialen liegenden Stellen zur Optimierung des angelegten elektrischen Feldes ausgebildet ist.

6. Verfahren zur Herstellung der Spannungsvervielfachereinrichtung für eine Hochspannungsanlage, insbesondere für Anwendungen in der Raumfahrt, gekennzeichnet durch folgende Schritte:

Druckformung eines Montagegrundkörpers für Schaltelemente, mit Löchern, die elektrische Entladungspfade od.dgl. unterbrechen;

Montieren der Schaltelemente durch Einsetzen und Verlöten der Anschlüsse der Schaltelemente in die Metallteile bzw. mit den Metallteilen, wie kleinen Kugeln oder Zylindern geeigneter Größe;

Umhüllen des Montagegrundkörpers mitsamt den Schaltelementen durch eine elektrostatische Abschirmung aus einem Drahtgitter;

Einfüllen eines Polyurethanharzes in flüssigem Zustand in die von der Abschirmung gebildete Umhüllung entweder unter sehr niedrigem Druck oder im Vakuum; und

Aushärtenlassen des Polyurethanharzes.

## Revendications

1. Dispositif multiplicateur de tension pour équipement haute tension, en particulier pour applications spatiales, comprenant une première section (2) comprenant des éléments de circuit tels que des résistances, des condensateurs et des diodes (7-9, 7'-9', 11, 12) reliés opérationnellement et fonctionnellement entre eux de manière à fournir une tension élevée, des moyens (5, 5', 15) pour optimiser le gradient de potentiel présent entre les éléments constitutifs de ladite première section (2), et une section d'entraînement (3), caractérisé en ce que des écrans électrostatiques (14) extérieurs à ladite première section (2) sont prévus pour contrôler le champ électrique présent, en ce que ledits éléments (7-9, 7'-9', 11, 12) sont portés sur une base de montage commune (4, 4') munie d'une pluralité d'orifices (5, 5') pour optimiser le gradient de potentiel, et en ce qu'aux bornes desdits éléments de circuit (7-9, 7'-9', 11, 12), ainsi qu'aux points d'interconnexion et de brasage (6, 6') sur la base de montage commune (4, 4') se trouvent des éléments métalliques présentant des surfaces (15) efficaces pour fournir une répartition améliorée et une réduction du champ électrique présent à l'intérieur de ladite première section multiplicatrice de tension (2).

2. Dispositif selon la revendication 1, caractérisé en ce que lesdits écrans électrostatiques (14) comprennent un treillis en fil métallique entourant complètement ladite première section multiplicatrice de tension (2).

3. Dispositif selon les revendications 1 et 2, caractérisé en ce que lesdits écrans électrostatiques (14) contrôlant le champ électrique sont maintenus au potentiel de terre.

4. Dispositif multiplicateur de tension selon la revendication 1, caractérisé en ce que lesdits éléments métalliques présentant des surfaces (15) sont sous la forme de petites billes ou cylindres brasés sur les bornes desdits éléments de circuit et de ladite base (4, 4').

5. Dispositif selon la revendication 1, caractérisé en ce que ladite première section multiplicatrice de tension (2) est enrobée de résine de polyuréthane qui présente une constante diélectrique élevée et qui est conçue pour fournir une isolation adéquate entre des points à des potentiels différents afin d'optimiser le champ électrique applique.

6. Procédé de fabrication du dispositif multiplicateur de tension pour équipment haute tension, en particulier pour applications spatiales, caractérisé en ce qu'il comprend les étapes consistant à:

mouler souss pression une base de montage pour des éléments de circuit, munie d'orifices interrompant le flux électrique de décharges et similaires;

monter lesdits éléments de circuit en insérant et brasant aux bornes desdits éléments des surfaces métalliques telles que de petites billes et cylindres de taille adéquate;

entourer ladite base munie desdits éléments de circuit au moyen d'un écran électrostatique consistant en un treillis en fil métallique;

remplir de résins de polyuréthane l'enceinte formée par ledit écran, soit sous très basse pression soit sous vide; et

laisser lesdites résines se solidifier.

Fig.1

Fig.3

Fig.5

Fig.2

Fig.6

Fig.7

Fig.8

0 090 193

Fig.4

Fig.9

Fig.10

Fig.11

Fig.12

0 090 193